# EUROPEAN PATENT APPLICATION

(11) **EP 0 933 876 A1**
(43) Date of publication of application: **04.08.1999**
(21) Application number: 99101095.0
(22) Date of filing: 26.01.1999
(51) Int. Cl.: H03M 7/30

(54) **Data compression method for packet transmission**

(30) Priority: 29.01.1998 US 15747
(71) Applicant: AT&T Corp., New York, NY 10013-2412 (US)
(72) Inventor: Bellovin, Steven Michael, Westfield, New Jersey 07090 (US)
(74) Representative: Modiano, Guido, Dr.-Ing.

(57) **Abstract**

A method provides for improved compression techniques over inherently unreliable underlying networks. A fixed compression dictionary is sent from a first terminal to a second terminal during the start up of a communications session between the terminals. The first terminal then compresses data in accordance with the transmitted fixed dictionary. The receiving terminal expands the compressed data in accordance with the received fixed dictionary. If packets are lost over the network such loss does not have a deleterious effect on the compression algorithm as in known adaptive compression techniques.

## Description

### BACKGROUND OF THE INVENTION

The present invention is directed to a method for improving data compression used over an unreliable underlying network. In particular, the present invention is directed to a method in which a compression dictionary is sent at the beginning of the communication session and is used by the communicating parties to control compression and expansion of the data transmitted over the unreliable underlying network.

It is known that it is beneficial to compress data streams which are transmitted over low speed lines so as to enhance the data flow rate over these lines. All modern modems perform some data compression. It is also known that it is beneficial to encrypt data so as to render it more secure thereby preventing access by parties who are not intended to receive the data.

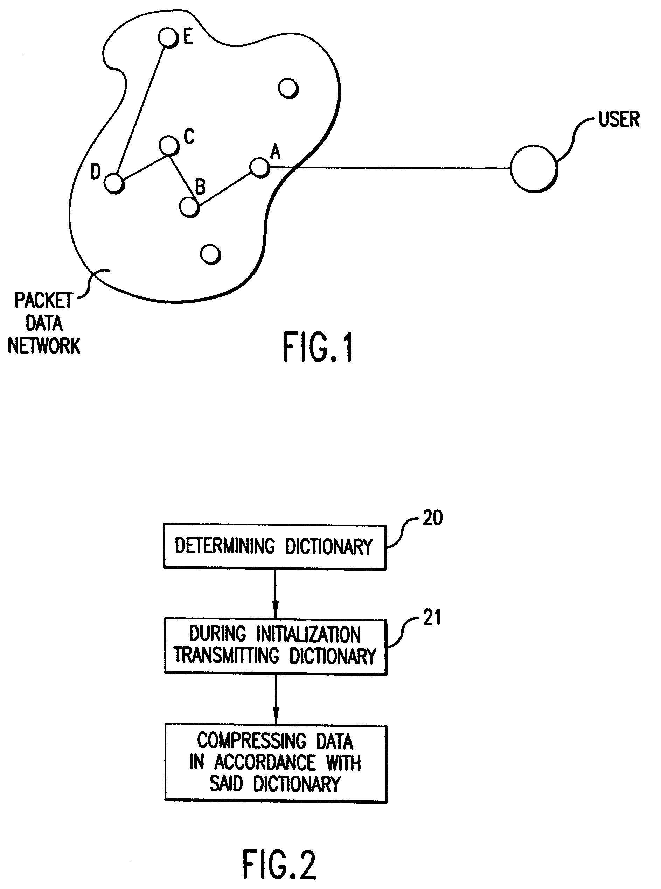

The Internet is a packet switching network in which large amounts of data can be transmitted between end points in a communication where compression may have some value. FIG. 1 illustrates a typical scenario where a party accessing the Internet is interested in obtaining information from or communicating with a host. The user has access to the Internet through an access provider, typically a point of presence (POP), e.g., A, and packets of data are transmitted via multiple routers (B to D) to and from host E. The question has arisen as to how to provide both encryption for the data and compression. Encrypted data creates a stream of apparently random bits and hence are inherently not compressible. One option therefore would be to provide encryption between points A to E without compression and then provide compression from access point A to the user without encryption. This however, leaves a significant portion of the link vulnerable since it carries unencrypted data.

Another option that has been considered is to perform compression first and then encrypt the compressed data and do this from end to end. There are some software costs associated with this scheme. However, it can be effective in a reliable network. Typically the compression algorithm used in such a configuration is adaptive compression whereby the compression dictionary is dynamic over the course of data transmission. Each succeeding packet of the data transmission has an impact on the dictionary. Thus, the compression of a later packet relies, at least in part, on the packets that preceded it. If a packet is not received at the expansion terminal, or if it is lost, it is difficult to expand the subsequent packets whose dictionary is in part based on the lost packet. While lost packets occasionally occur in a reliable network, this does not pose significant problems for the adaptive compression scheme.

However, at its heart the Internet is based on an unreliable datagram network. Packets tray be dropped, damaged, duplicated, reordered or even "invented" by the network. This can pose significant problems for adaptive compressions. It is more likely that packets will not be properly received so that the receiving terminal will not be able to expand packets downstream of the "lost" packet.

One proposed solution would be to periodically recreate the dictionary. In essence, the system could select a predetermined number of packets for creating a given dictionary and then after that number of packets has been passed downstream a new dictionary would begin. In this scenario, if one of the packets within a given group of n packets is lost then only those packets of data within the group and following the lost packet are negatively affected. The dictionary is recreated at the beginning at the next n packets. This technique will only be effective if the number of packets "n" is carefully selected based on the loss characteristics of the medium. The inventor has discovered that for a packet loss probability of 5% a burst rate of 4. that is n=4, yields an effective loss rate of 12%. This effective loss rate is too high and can create other transmission problems. In fact, a high loss rate leads to even greater retransmission of packets causing a greater traffic jam with further packet loss due to packet discarding operations. Furthermore, in TCP packet loss is treated as a sign of congestion. In response, it backs off on its transmission rate. This slows down throughout considerably which negates the beneficial effects of compression. The effect of a high loss rate is further described in "Round Trip Time Estimation" P. Karn and C. Partridge, ACM SIGCOMM-87, August 1987 and "Congestion Avoidance and Control," V. Jacobson, ACM SIGCOMM-88, August 1988. With a packet loss probability of 5% it might be possible to employ a burst rate of 2, that is, n=2 since the effective loss rate would be about 7%. For a packet loss probability of greater than 6%, it would be necessary to use a burst size of 1, that is, n=1, to be able to keep the effective loss rate < 10%. A burst rate of 1 means that the entire compression dictionary must be sent with each packet of information. This is a rather substantial overhead cost to pay for providing compression especially since it is known that the majority of the packets are of small size (40 bytes) and inclusion of the entire dictionary in packets of this size would be excessive.

It would be beneficial if a compression technique could be provided for unreliable underlying networks without excessive overhead costs.

### SUMMARY OF THE INVENTlON

The present invention provides an improved compression scheme which permits compression over a packet data network that is inherently unreliable. In particular, the present invention provides that during a communication session between two terminals at least one terminal transmits a fixed compression dictionary to the other terminal. Subsequent communications from the first terminal to the second terminal will include data compressed in accordance with this fixed compression dictionary. A second terminal will then be able to use the received dictionary to expand the received data. By using a fixed compression dictionary there is no negative effect on subsequent packets of data if one of the preceding packets of data has been lost due to the general nature of the lossy medium. Furthermore, the transmission of a fixed compression dictionary, which could be at the beginning of the session, avoids the need for transmitting an adaptive dictionary with every packet which creates excessive overhead costs.

In accordance with the present invention the two terminals could use the same fixed compression dictionary for compressing and expanding data during the communication between the two terminals. Alternatively, each terminal could specify to the other terminal the fixed compression dictionary that the terminal will be using to transmit data to that other terminal. For instance, terminal A could have a fixed compression dictionary that it uses for compressing data transmitted to terminal B while terminal B could have a separate fixed compression dictionary for the compressed data it transmits to terminal A.

The fixed compression dictionary could be generated at the beginning of this session based on the type of data to be transmitted from the compressing terminal to the expanding terminal. The dictionary could be changed from session to session or it could remain fixed over all sessions. Other modifications of the content of the fixed dictionary and the way in which the terminals share the dictionary can be implemented.

### BRIEF DESCRIPTION OF THE DRAWINGS

FIG. 1 illustrates in schematic form of a network arrangement in which data may be compressed and encrypted.
FIG. 2 provides a flow diagram for operations to be performed by a terminal compressing data in accordance with the present invention.
FIG. 3 provides a flow chart showing the steps to be performed by the terminal receiving compressed data in accordance with the present invention.
FIG. 4 illustrates a simple block diagram of the terminal communication configuration in which the present invention may be used.

### DETAILED DESCRIPTION

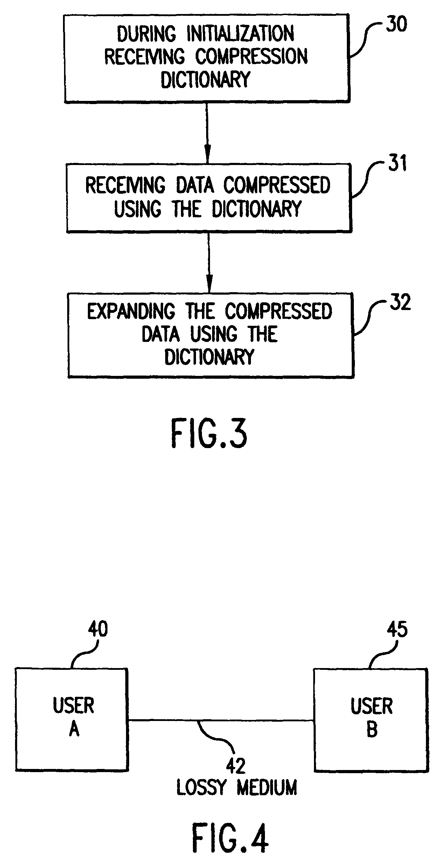

FIG. 4 illustrates a simple block diagram of a connection of two data terminals over a lossy transmission medium. The data terminals may exchange data of many different types, e.g., voice data, video, text, executable text, etc.

While it is not significant for purposes of this invention which terminal initiates a session, for ease of discussion it will be assumed in these examples that terminal A, 40, has initiated a communication session with terminal B, 45. After terminal A initiates the session it transmits a fixed compression dictionary to terminal B as part of the call set up or session start up exchange. The compression dictionary would define to terminal B the dictionary that terminal A will be using to compress data to be transmitted to terminal B. In an alternative arrangement terminal A sends a pointer B and the pointer identifies from where terminal B can retrieve the compression dictionary. Upon receipt of this compression dictionary, terminal B will store the fixed compression dictionary for use with its communication with terminal A. Then, in accordance with the steps shown in FIG. 2, terminal A having determined the dictionary (step 20) and transmitted the dictionary during initialization (step 21), compresses the data in accordance with the dictionary (step 22) and transmits it to terminal B.

In accordance with the steps shown in FIG. 3, terminal B receives the compressed data (step 31) and subsequently expands the compressed data using the dictionary (step 32).

In one possible implementation, terminal A defines the compression dictionary for all communications between terminal A and B, that is both terminals compress data in accordance with the dictionary and both terminals expand received data in accordance with the dictionary. Alternatively, terminal B, during the start up exchange, could send a second fixed dictionary to terminal A thereby defining to terminal A the dictionary that terminal B will be using to compress data as it transmits information to terminal A.

The compression dictionary that is transmitted could be generated in a number of different ways. First, the terminal transmitting the compression dictionary may simply access a portion of its memory which stores a dictionary which remains static over time and is used for all communications by that terminal. Alternatively, the terminal, for example, terminal A, could store multiple static dictionaries: each dictionary would be associated with a particular type of data transmission that the terminal will be engaging in. Then, at the beginning of the session, the terminal could select the appropriate static dictionary based on the data type to be employed in that given transmission. In another modification the terminal transmitting the dictionary could generate a new dictionary at the beginning of every session. The terminal could use software previously loaded on the terminal or it could use software downloaded from some other terminal in the packet switching network to create a dictionary that is particularly suited to this session.

The dictionary can actually be constituted by different portions, which themselves may be either static or generated on a per session basis. Examples of possible components of the dictionary would be: a starting dictionary that could be based on the type of text being transmitted (language text or executable text); information regarding the data type involved in the transmission between the two terminals; TCP connection state information, for example, an initial sequence number to be used, which can be used as part of TCP header compression techniques which are already known. Examples of the compression techniques are described in a paper entitled "Compressing JCP/IP Headers for Low-Speed Serial Links," by V. Jacobson, Feb. 1990, hereby incorporated herein by reference.

The transmission of the fixed compression dictionary at the start of the session facilitates compression over the lossy medium without exorbitant overhead costs.

The above description has referred to a simple two terminal connection. It should be noted that the present invention is also applicable to a multi-terminal connection, for example a multi-cast operation. The implementation would simply be adjusted to advise the multiple terminals of the fixed dictionary or dictionaries to be used. This could be done at the terminal point where each terminal joins the multi-cast.

The present invention is not limited to the arena of the Internet. Instead, it could be employed over any inherently unreliable underlying network over which packets of data are being transmitted.

In addition, it might be possible to use the fixed compression dictionary transmitted at the beginning of the session as a primary or base line dictionary which could be supplemented by adaptive compression schemes. As a consequence, as packets are created and transmitted the dictionary could be expanded. But if packets are lost during the course of the transmission the basic dictionary will still be available for expansion of the received packets that follow the lost packet.

In accordance with the present invention the flow of data between two or more terminals can be compressed and expanded even though they are impressed upon inherently unreliable underlying networks.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A method for data transmission between two terminals over a packet-data transmission medium, the method comprising the steps of:
initiating a communication session over the packet data transmission medium;
transmitting a fixed compression dictionary after prompting from a first terminal;
at said first terminal, compressing packet data in accordance with said fixed compression dictionary; and
transmitting the compressed packet data from the first terminal to the second terminal over the packet data transmission medium.

2. The method of claim 1 wherein said step of transmitting the fixed compression dictionary comprises the substeps of:
transmitting a pointer from the first terminal to the second terminal; and
retrieving to the second terminal the fixed compression dictionary using said pointer.

3. The method of claim 1 wherein said step of transmitting the fixed compression dictionary comprises the substep of transmitting the fixed compression dictionary from the first terminal to the second terminal.

4. The method of claim 1 wherein said fixed compression dictionary includes a starting data compression dictionary.

5. The method of claim 4 wherein said fixed compression dictionary further includes a header compression dictionary.

6. A method for receiving at a first terminal, a data transmission from a second terminal, over a packet-data transmission medium, the method comprising the steps of:
receiving a fixed compression dictionary from the first terminal;
receiving from the first terminal packet-data compressed in accordance with said fixed compression dictionary; and
decompressing the received packet data in accordance with the received fixed compression dictionary.

7. The method of claim 6 wherein said fixed compression dictionary includes a starting data compression dictionary.

8. The method of claim 7 wherein said fixed compression dictionary further includes a header compression dictionary.

9. A method for communication of data between a first terminal and a second terminal over a packet data transmission medium, the method comprising the steps of:
initiating a communication session between the first and second terminals over the packet data transmission medium;
transmitting a fixed compression dictionary from the first terminal to the second terminal;
receiving from the first terminal packet-data compressed in accordance with said first compression dictionary; and
decompressing, at the second terminal, the received compressed packet data in accordance with said fixed compression dictionary.

10. The method of claim 9 comprising the further step of:
compressing packet data at said first terminal in accordance with said fixed compression dictionary; and
transmitting the packet-data compressed at said first terminal to said second terminal.

11. The method of claim 9 wherein said fixed compression dictionary includes a starting data compression dictionary.

12. The method of claim 11 wherein said fixed compression dictionary further includes a header compression dictionary.

13. The method of claim 10 wherein said fixed compression dictionary includes a starting data compression dictionary.

14. The method of claim 13 wherein said fixed compression dictionary her includes a header compression dictionary.

15. In a data packet transmission system including a first and a second terminal, a communication method comprising the steps of:
initializing a communication session between the first and second terminals, wherein during the initializing the first terminal receives a fixed compressing dictionary from the second terminal;
receiving packet-data from the first terminal, the received packet-data being compressed in accordance with said fixed compression dictionary; and
decompressing the received packet data in accordance with the received fixed compression dictionary.

16. The method of claim 15 wherein the content of said fixed compression dictionary is selected by the second terminal in accordance with the type of data to be transmitted.

17. The method of claim 15 wherein the content of said fixed compression dictionary is generated in accordance with the type of data to be transmitted.

18. The method of claim 15 further comprises the step of said first terminal compressing data in accordance with said fixed compression dictionary for transmission to said second terminal.

19. The method of claim 15 further comprising the steps of:
transmitting a second fixed compression dictionary from the first terminal to the second terminal; and
compressing data in accordance with said second fixed compression dictionary for transmitting to said second terminal.
